Europäisches Patentamt

European Patent Office

Office européen des brevets

(19)

(11) **EP 0 845 856 B1**

(12) **FASCICULE DE BREVET EUROPEEN**

(45) Date de publication et mention
de la délivrance du brevet:
**20.02.2002 Bulletin 2002/08**

(51) Int Cl.⁷: **H03F 1/26**, H03F 3/45

(21) Numéro de dépôt: **97410135.4**

(22) Date de dépôt: **26.11.1997**

(54) **Amplificateur à transconductance à dynamique élevée et faible bruit**

Rauscharmer Transkonduktanzverstärker mit hoher Aussteuerung

High swing low noise transconductance amplifier

(84) Etats contractants désignés:
**DE FR GB IT**

(30) Priorité: **29.11.1996 FR 9614898**

(43) Date de publication de la demande:
**03.06.1998 Bulletin 1998/23**

(73) Titulaire: **STMicroelectronics S.A.**
**92120 Montrouge (FR)**

(72) Inventeur: **Van Zalinge, Klaas**
**38240 Meylan (FR)**

(74) Mandataire: **de Beaumont, Michel**
**1, rue Champollion**
**38000 Grenoble (FR)**

(56) Documents cités:
**EP-A- 0 448 951**        **DE-A- 3 225 405**
**US-A- 4 460 872**

## Description

La présente invention concerne un amplificateur différentiel à transconductance et plus particulièrement un amplificateur à transconductance de précision dont tous les transistors sont d'un même type de conductivité.

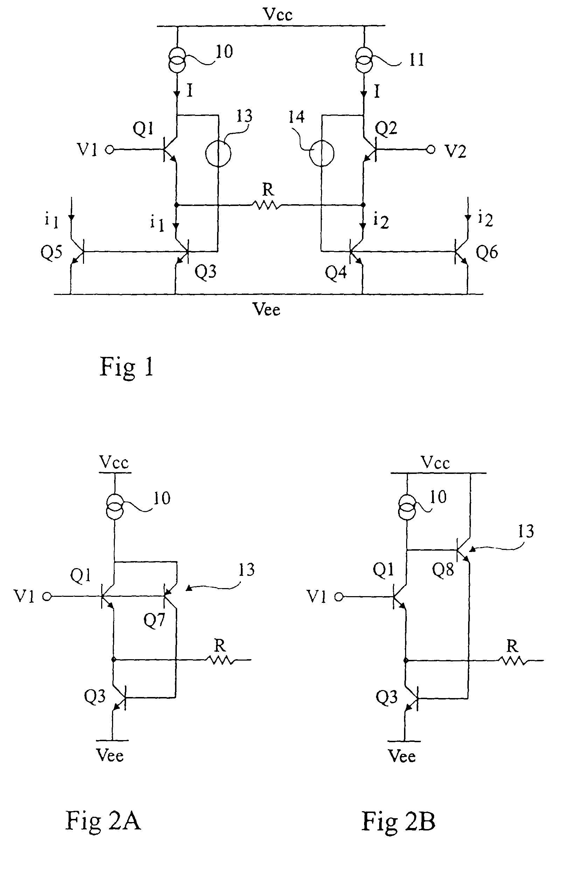

La figure 1 représente schématiquement une structure classique d'un tel amplificateur à transconductance de précision. L'amplificateur comprend un premier couple de transistor NPN Q1 et Q2 dont les collecteurs sont couplés à une tension d'alimentation haute Vcc par des sources de courant respectives 10 et 11. Les sources de courant 10 et 11 délivrent chacune un même courant I. Une résistance R est connectée entre les émetteurs des transistors Q1 et Q2. Les bases des transistors Q1 et Q2 reçoivent respectivement deux composantes V1 et V2 d'une tension d'entrée différentielle.

Les émetteurs de deux transistors NPN Q3 et Q4 sont reliés à une tension d'alimentation basse Vee et leurs collecteurs sont reliés respectivement aux émetteurs des transistors Q1 et Q2. Les bases des transistors Q3 et Q4 sont reliées respectivement aux collecteurs des transistors Q1 et Q2 par l'intermédiaire de circuits de décalage 13 et 14. Le but de ces circuits de décalage est de commander les bases des transistors Q3 et Q4 à un potentiel adéquat à partir des collecteurs des transistors Q1 et Q2.

La sortie de cet amplificateur est un courant différentiel $i_1$-$i_2$, où $i_1$ et $i_2$ désignent les variations de courant respectives dans les transistors Q3 et Q4. Ce courant différentiel de sortie est exprimé par

$$i_1\text{-}i_2 = -2(V1\text{-}V2)/R$$

avec une erreur de l'ordre de $1/\beta^2$, où $\beta^2$ est le produit des gains des transistors Q1 et Q3 ou Q2 et Q4.

Le fait que les transistors Q1 à Q4 soient tous des transistors NPN augmente la précision et la vitesse par rapport aux structures utilisant une combinaison de transistors NPN et PNP, puisque les transistors PNP ont notablement moins de gain et bande passante que les transistors NPN.

Un problème que l'on rencontre dans la structure de la figure 1 est lié à la difficulté à obtenir un rapport signal/bruit élevé ou une dynamique élevée. La limite inférieure de la dynamique est déterminée par le bruit en entrée de l'amplificateur, tandis que la limite supérieure est idéalement déterminée par la tension d'alimentation Vcc.

La valeur la plus élevée possible des tensions V1 et V2 dépend de la structure des circuits décaleurs 13 et 14.

Pour que les tensions V1 et V2 puissent atteindre la valeur la plus basse possible, les émetteurs des transistors Q3 et Q4 sont directement reliés à la tension d'alimentation basse Vee et leurs courants $i_1$ et $i_2$ sont recopiés dans des transistors NPN respectifs Q5 et Q6. Les transistors Q5 et Q6 sont connectés en parallèle par leurs bases et leurs émetteurs aux transistors Q3 et Q4. Les courants de sortie $i_1$ et $i_2$ sont alors prélevés des collecteurs des transistors Q5 et Q6.

Avec cette structure, chacune des tensions V1 et V2 peut atteindre une valeur aussi basse que

$$\text{Vee} + \text{Vces} + \text{Vbe}$$

où Vces est la tension collecteur-émetteur de saturation des transistors Q3 et Q4, et Vbe la tension base-émetteur des transistors Q1 et Q2.

Le bruit total à l'entrée de l'amplificateur peut être exprimé par

$$N\ (V^2/Hz) = 4kT(2r_b + r_e + R) + 4kTZ_s + 2kTZ_s^2/\beta r_e$$

où $r_b$ et $r_e$ sont les résistances de base et d'émetteur des transistors d'entrée Q1 et Q2, et $Z_s$ est l'impédance de sortie de la source qui fournit les tensions V1 et V2.

En outre, la résistance de base peut être exprimée par

$$r_e = kT/qI_c$$

où $I_c$ est le courant de collecteur des transistors d'entrée Q1 et Q2. (k, T et q sont la constante de Boltzmann, la température absolue, et la charge d'un électron).

Ce bruit à l'entrée a une valeur minimale pour

$$r_e = Z_s/\sqrt{2}\beta$$

ou

$$I_c = \sqrt{2}\beta\ kT/qZ_s$$

qui détermine la valeur optimale des courants de collecteur des transistors Q1 et Q2, donc la valeur optimale Iopt des courants fournis par les sources 10 et 11.

Le courant de sortie différentiel $i_1$-$i_2$ peut atteindre une valeur maximale de 2I. Toutefois, pour éviter une distorsion, la valeur 2I est choisie supérieure à la valeur maximale désirée pour $i_1$-$i_2$. Dans de nombreux cas, notamment lorsque l'impédance $Z_s$ est élevée, il ne sera pas possible de choisir une valeur 2I qui garantisse à la fois des caractéristiques de bruit d'entrée optimales et un signal de sortie maximal sans distorsion.

Les figures 2A et 2B illustrent toutes deux une moitié de l'amplificateur à transconductance de la figure 1, incorporant deux exemples différents d'un circuit de décalage 13.

Dans la figure 2A, le circuit de décalage 13 comprend un transistor PNP Q7 dont la base est reliée à la base du transistor Q1. L'émetteur du transistor Q7 est relié au collecteur du transistor Q1 et son collecteur est relié à la base du transistor Q3.

Avec cette configuration, la tension de collecteur du transistor Q1 est fixée à V1 + Vbe, où Vbe est la tension base-émetteur du transistor Q7. Par conséquent, la tension V1 ne peut dépasser la valeur Vcc-Vsat-Vbe, où Vsat est la tension de saturation de la source de courant 10 (habituellement un transistor). Le transistor Q7 présente l'inconvénient d'ajouter un bruit significatif à l'entrée de l'amplificateur, puisque la base du transistor Q7 est reliée à l'entrée de l'amplificateur.

La figure 2B représente un exemple de circuit de décalage 13 qui n'ajoute aucun bruit d'entrée à l'amplificateur. Le circuit de décalage 13 comprend un transistor NPN Q8 dont la base est reliée au collecteur du transistor Q1. Le collecteur du transistor Q8 est couplé au potentiel Vcc, et son émetteur est couplé à la base du transistor Q3.

Avec cette configuration, la tension V1 ne peut toutefois dépasser la valeur Vee + 3Vbe - Vces, où Vces est la tension collecteur-émetteur de saturation du transistor Q1. Cette valeur peut être augmentée en insérant des diodes entre l'émetteur du transistor Q8 et la base du transistor Q3, mais la tension d'alimentation de l'amplificateur devrait alors être relativement élevée.

Un objet de la présente invention est de prévoir un amplificateur à transconductance de précision présentant une dynamique élevée.

Cet objet est atteint grâce à un amplificateur à transconductance différentiel comprenant deux premiers transistors bipolaires d'un premier type de conductivité, dont les bases reçoivent une tension d'entrée différentielle, et dont les collecteurs sont reliés à un premier potentiel d'alimentation par deux premières sources de courant respectives ; deux deuxièmes transistors bipolaires du premier type de conductivité, reliant respectivement les émetteurs des premiers transistors à un deuxième potentiel d'alimentation, et dont les bases sont reliées aux collecteurs des premiers transistors respectifs par des circuits de décalage ; et un moyen résistif relié entre les émetteurs des premiers transistors. Une deuxième source de courant est reliée entre le premier potentiel d'alimentation et le noeud de connexion entre deux résistances reliées en série constituant ledit moyen résistif.

Cet objet est également atteint grâce à un amplificateur à transconductance différentiel comprenant deux premiers transistors bipolaires d'un premier type de conductivité, dont les bases reçoivent une tension d'entrée différentielle, et dont les collecteurs sont reliés à un premier potentiel d'alimentation par deux premières sources de courant respectives ; deux deuxièmes transistors bipolaires du premier type de conductivité, reliant respectivement les émetteurs des premiers transistors à un deuxième potentiel d'alimentation, et dont les bases sont reliées aux collecteurs des premiers transistors respectifs par des circuits de décalage ; et un moyen résistif relié entre les émetteurs des premiers transistors. Chaque circuit de décalage comprend un troisième transistor d'un deuxième type de conductivité, relié entre le collecteur du premier transistor respectif et la base du deuxième transistor respectif, et dont la borne de commande reçoit une tension de polarisation constante indépendante de la tension différentielle d'entrée.

Selon un mode de réalisation de la présente invention, la tension de polarisation est choisie décalée par rapport au premier potentiel d'alimentation d'une valeur sensiblement égale à la tension de saturation de la première source de courant respective, augmentée de la chute de tension entre la borne de commande du troisième transistor et le collecteur du premier transistor respectif.

Selon un mode de réalisation de la présente invention, le premier type de conductivité est N.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1, précédemment décrite, représente un amplificateur à transconductance de précision classique dont tous les transistors sont de type NPN ;
les figures 2A et 2B, précédemment décrites, représentent deux exemples différents d'un circuit de décalage utilisable dans le circuit de la figure 1 ;
la figure 3 représente un mode de réalisation d'amplificateur à transconductance selon la présente invention ; et
la figure 4 représente un deuxième mode de réalisation d'un amplificateur à transconductance selon l'invention, combiné au mode de réalisation de la figure 3.

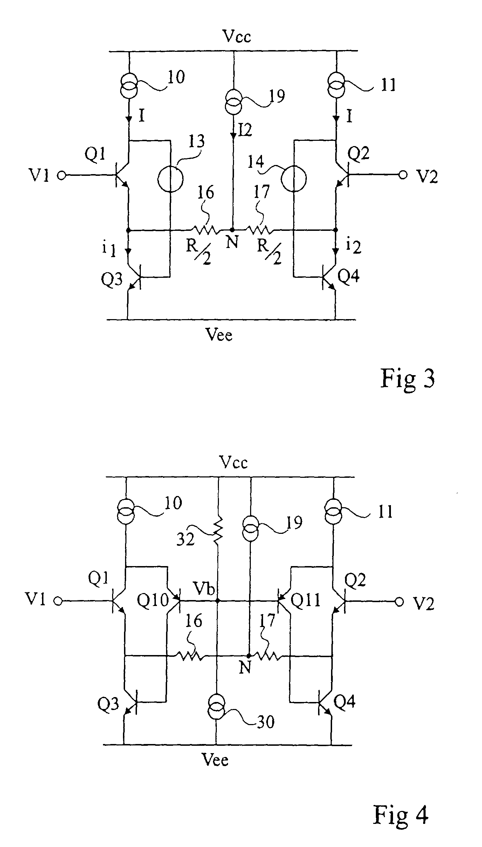

Dans la figure 3, des mêmes éléments qu'à la figure 1 sont désignés par des mêmes références. Selon l'invention, la résistance R de la figure 1 est remplacée, dans la figure 3, par deux résistances 16, 17 reliées en série entre les émetteurs des transistors Q1 et Q2. Les résistances 16 et 17 ont de préférence une même valeur R/2. Le noeud de connexion N entre les résistances 16 et 17 est relié au potentiel d'alimentation haut Vcc par une source de courant 19 fournissant un courant I2.

En fonctionnement, lorsque les tensions V1 et V2 sont égales, le courant I2 est également réparti entre les résistances 16 et 17, d'où il résulte que chacun des courants de sortie $i_1$ et $i_2$ est égal à I+I2/2. La tension au noeud N est alors plus élevée que les tensions d'émetteur des transistors Q1 et Q2.

Lorsque la tension V1 augmente par rapport à la tension V2, le courant dans la résistance 16 décroît tandis que le courant dans la résistance 17 croît, jusqu'à ce qu'aucun courant ne circule dans la résistance 16 et tout le courant I2 circule dans la résistance 17. Alors, le courant de sortie il est égal à I et le courant de sortie $i_2$ est égal à I+I2.

Si la tension V1 continue à croître, une partie du courant I fourni par la source 10 commence à circuler dans la résistance 16 vers le noeud N. Lorsque la tension V1 atteint une valeur maximale, tout le courant I de la source 10 circule dans la résistance 16, d'où il résulte que le courant de sortie $i_1$ est nul et le courant de sortie $i_2$ est égal à 2I+I2.

Ainsi, le courant de sortie différentiel $i_1$-$i_2$ a une valeur maximale de 2I+I2 qui est déterminée à la fois par les sources de courant 10 et 11 et par la source de courant 19. Le courant I délivré par les sources 10 et 11 peut être choisi à une valeur optimale pour réduire le bruit d'entrée. Puisque le courant I2 fourni par la source 19 n'a aucune influence sur les courants dans les transistors d'entrée Q1 et Q2, il n'affecte pas le bruit d'entrée et peut donc être choisi librement pour établir le courant de sortie différentiel maximal.

Pourvu que chacune des résistances 16 et 17 ait la valeur moitié de la résistance R de la figure 1, le courant de sortie différentiel a la même expression que celui de la figure 1, c'est-à-dire :

$$i_1\text{-}i_2 = -2(V1\text{-}V2)/R.$$

Le mode de réalisation de la figure 3 permet d'accroître la dynamique de l'amplificateur à transconductance par une réduction de son bruit d'entrée.

La figure 4 représente un mode de réalisation de l'invention permettant d'accroître la dynamique de l'amplificateur par une augmentation de l'amplitude maximale des tensions d'entrée V1 et V2 sans accroître le bruit d'entrée.

Pour cela, chacun des circuits de décalage 13 et 14 comprend un transistor de type P Q10, Q11. Ces transistors de type P peuvent être des transistors PNP, comme cela est représenté. Dans une technologie BI-CMOS, les transistors Q10 et Q11 pourraient également être des transistors MOS à canal P.

Les émetteurs des transistors Q10 et Q11 sont respectivement connectés aux collecteurs des transistors Q1 et Q2, et leurs collecteurs sont respectivement connectés aux bases des transistors Q3 et Q4. Les bases des transistors Q10 et Q11 reçoivent une même tension de polarisation Vb.

La tension de polarisation Vb détermine la valeur maximale des tensions V1 et V2, cette valeur maximale étant

$$Vb + 2Vbe - Vces$$

où Vces désigne la tension collecteur-émetteur de saturation des transistors Q1 et Q2. De préférence, la tension Vb est choisie aussi élevée que possible pour accroître la valeur maximale des tensions V1 et V2, et donc la dynamique. La valeur la plus élevée possible de la tension Vb est

$$Vcc - Vbe - Vsat$$

où Vsat est la tension de saturation des sources de courant 10 et 11 (habituellement des transistors). Alors, la valeur maximale des tensions V1 et V2 est

$$Vcc + Vbe - Vces - Vsat.$$

Les tensions Vces et Vsat sont sensiblement égales et habituellement inférieures à Vbe/2, d'où il résulte que les tensions V1 et V2 peuvent atteindre une valeur légèrement supérieure Vcc. Ce gain (Vbe+Vsat) dans l'amplitude maximale par rapport au circuit de décalage représenté à la figure 2A est d'autant plus significatif que la tension d'alimentation de l'amplificateur est basse.

La tension Vb est obtenue, par exemple, en connectant les bases des transistors Q10 et Q11 au potentiel Vee par une source de courant 30 et au potentiel Vcc par une résistance 32. Les valeurs de la source de courant 30 et de la résistance 32 sont choisies pour obtenir la tension souhaitée Vbe + Vsat aux bornes de la résistance 32. Cette tension souhaitée est obtenue indépendamment de la tension d'alimentation Vcc, qui peut être aussi faible que Vbe + 2Vsat.

Dans la figure 4, les circuits de décalage avantageux Q10 et Q11 sont représentés en combinaison avec le mode de réalisation de la figure 3. Le mode de réalisation de la figure 4 permet donc d'accroître la dynamique aussi bien en réduisant le niveau du bruit d'entrée qu'en augmentant l'amplitude maximale du signal d'entrée différentiel.

De nombreuses variantes et modifications de la présente invention apparaîtront à l'homme du métier. Par exemple, les transistors Q1 à Q4 ont été décrits en tant que transistors NPN, car l'amplificateur présente alors les meilleures caractéristiques de précision et de vitesse. Les transistors peuvent être remplacés par des transistors de type conductivité opposé, ce qui affectera la précision et la vitesse, mais pas la dynamique.

**Revendications**

1. Amplificateur à transconductance différentiel comprenant :

   - deux premiers transistors bipolaires (Q1, Q2) d'un premier type de conductivité, dont les bases reçoivent une tension d'entrée différentielle (V1-V2), et dont les collecteurs sont reliés à un premier potentiel d'alimentation (Vcc) par deux premières sources de courant respectives (10, 11) ;

- deux deuxièmes transistors bipolaires (Q3, Q4) du premier type de conductivité, reliant respectivement les émetteurs des premiers transistors à un deuxième potentiel d'alimentation (Vee), et dont les bases sont reliées aux collecteurs des premiers transistors respectifs par des circuits de décalage (13, 14) ; et

- un moyen résistif (R) relié entre les émetteurs des premiers transistors ;

**caractérisé en ce que** chaque circuit de décalage (13, 14) comprend un troisième transistor (Q10, Q11) d'un deuxième type de conductivité, relié entre le collecteur du premier transistor respectif et la base du deuxième transistor respectif, et dont la borne de commande reçoit une tension de polarisation constante (Vb) indépendante de la tension différentielle d'entrée.

**2.** Amplificateur selon la revendication 1, **caractérisé en ce qu'**il comprend une deuxième source de courant (19) reliée entre le premier potentiel d'alimentation (Vcc) et le noeud de connexion (N) entre deux résistances reliées en série (16, 17) constituant le moyen résistif.

**3.** Amplificateur selon la revendication 1, **caractérisé en ce que** la tension de polarisation (Vb) est choisie décalée par rapport au premier potentiel d'alimentation (Vcc) d'une valeur sensiblement égale à la tension de saturation de la première source de courant respective (10, 11), augmentée de la chute de tension entre la borne de commande du troisième transistor et le collecteur du premier transistor respectif.

**4.** Amplificateur selon l'une quelconque des revendications 1 à 3, **caractérisé en ce que** le premier type de conductivité est N.

**Patentansprüche**

**1.** Differentialtranskonduktanzverstärker, mit

zwei ersten bipolaren Transistoren (Q1, Q2) eines ersten Leitfähigkeitstyps, deren Basen eine Differenzeingangsspannung (V1-V2) empfangen und deren Kollektoren mit einer ersten Versorgungsspannung (Vcc) über zwei entsprechende erste Stromquellen (10, 11) verbunden sind; zwei zweiten bipolaren Transistoren (Q3, Q4) des ersten Leitfähigkeitstyps, welche jeweils die Emitter der ersten Transistoren mit einer zweiten Versorgungsspannung (Vee) verbinden und deren Basen mit den Kollektoren der jeweiligen ersten Transistoren über Pegelschieber (13, 14) verbunden sind; und eine ohm'sche Einrichtung (R), die zwischen den Emittern der ersten Transistoren angeschlossen ist;

**dadurch gekennzeichnet, daß** jeder Pegelschieber (13, 14) einen dritten Transistor (Q10, Q11) eines zweiten Leitfähigkeitstyps aufweist, der zwischen dem Kollektor des jeweiligen ersten Transistors und der Basis des jeweiligen zweiten Transistors angeschlossen ist, und dessen Steueranschluß eine konstante Vorspannung (Vb) unabhängig von der Differenzeingangsspannung erhält.

**2.** Verstärker nach Anspruch 1, **dadurch gekennzeichnet, daß** er eine zweite Stromquelle (19) aufweist, die zwischen der ersten Versorgungsspannung (Vcc) und dem Verbindungsknoten (N) zwischen zwei in Reihe geschalteten Widerständen (16, 17), welche die ohm'sche Einrichtung bilden, angeschlossen ist.

**3.** Verstärker nach Anspruch 1, **dadurch gekennzeichnet, daß** die Vorspannung (Vb) mit einem Offset von der ersten Versorgungsspannung (Vcc) gewählt wird, der einen Wert hat, der im wesentlichen gleich der Sättigungsspannung der entsprechenden ersten Stromquelle (10, 11) plus der Spannungsabfall zwischen dem Steueranschluß des dritten Transistors und dem Kollektor des entsprechenden ersten Transistors ist.

**4.** Verstärker nach einem der Ansprüche 1 bis 3, **dadurch gekennzeichnet, daß** der erste Leitfähigkeitstyp N ist.

**Claims**

**1.** A differential transconductance amplifier comprising:

- two first bipolar transistors (Q1, Q2) of a first conductivity type, whose bases receive a differential input voltage (V1-V2), and whose collectors are coupled to a first supply voltage (Vcc) through two respective first current sources (10, 11);

- two second bipolar transistors (Q3, Q4) of the first conductivity type, respectively coupling the emitters of the first transistors to a second supply voltage (Vee), and whose bases are coupled to the collectors of the respective first transistors through level shifters (13, 14); and

- a resistive means (R) coupled between the emitters of the first transistors;

**characterized in that** each level shifter (13, 14) comprises a third transistor (Q10, Q11) of a second conductivity type, coupled between the collector of the respective first transistor and the base of the respective second transistor, and whose control terminal receives a constant bias voltage (Vb) independent of the differential input voltage.

2. The amplifier of claim 1, **characterized in that** it comprises a second current source (19) coupled between the first supply voltage (Vcc) and the connection node (N) between two series connected resistors (16, 17) forming the resistive means.

3. The amplifier of claim 1, **characterized in that** the bias voltage (Vb) is chosen offset from the first supply voltage (Vcc) of a value substantially equal to the saturation voltage of the respective first current source (10, 11), plus the voltage drop between the control terminal of the third transistor and the collector of the respective first transistor.

4. The amplifier of any of claims 1 to 3, **characterized in that** the first conductivity type is N.

Fig 1

Fig 2A

Fig 2B

Fig 3

Fig 4